# EUROPEAN PATENT SPECIFICATION

(11) **EP 2 302 093 B1**
(45) Date of publication and mention of the grant of the patent: **31.10.2012**
(21) Application number: 09773295.2
(22) Date of filing: 16.06.2009
(51) Int. Cl.: C23C 14/48, G02B 5/28, C23C 14/00, C23C 14/22, C23C 14/08, C23C 14/10, C23C 14/30, G02B 1/10, H01J 37/32

(54) **Deposition apparatus and manufacturing method of thin film device.**
Bedampfungsvorrichtung und Verfahren zur Herstellung einer Dünnfilmvorrichtung.
Appareil et procédé de dépôt pour fabriquer un dispositif à couches minces.

(30) Priority: 30.06.2008 JP 2008171113
(43) Date of publication of application: 30.03.2011
(73) Proprietor: Shincron Co., Ltd., Kanagawa 220-8680 (JP)
(72) Inventor: SHIONO, Ichiro, Yokohama-shi Kanagawa 220-8680 (JP); JIANG, Yousong, Yokohama-shi Kanagawa 220-8680 (JP); NAGAE, Ekishu, Yokohama-shi Kanagawa 220-8680 (JP); HONDA, Hiromitsu, Yokohama-shi Kanagawa 220-8680 (JP); MURATA, Takanori, Yokohama-shi Kanagawa 220-8680 (JP)
(74) Representative: Grünecker, Kinkeldey, Stockmair & Schwanhäusser
(86) International application number: PCT/JP2009/060938
(87) International publication number: WO 2010/001717

(56) References cited:
- JP-A- 4 318 162
- JP-A- 59 139 930
- JP-A- 2005 344 131
- JP-A- 2007 248 828

## Description

### Technical Field

The present invention relates to a deposition apparatus of a thin film, particularly to a deposition apparatus in which an inner wall of a vacuum chamber is electrically floating, and a manufacturing method of a thin film device such as an optical filter manufactured using this deposition apparatus.
It should be noted that in the specification, the term electrically "floating" indicates an electrically insulated state from the other members.

### Background Art

Conventionally, there is a known deposition apparatus for performing densification by irradiating ions to deposition layers deposited on substrates at the time of evaporating thin film materials toward surfaces of the substrates in a vacuum chamber (an ion assist deposition apparatus). In such a deposition apparatus, by irradiating gas ions having relatively low energy to the substrates with an ion gun and irradiating neutral electrons (electrons) to the substrates with a neutralizer, densified films can be manufactured by motion energy of the gas ions while neutralizing a bias of an electric charge on the substrates due to the gas ions (for example, Patent Documents 1, 2).

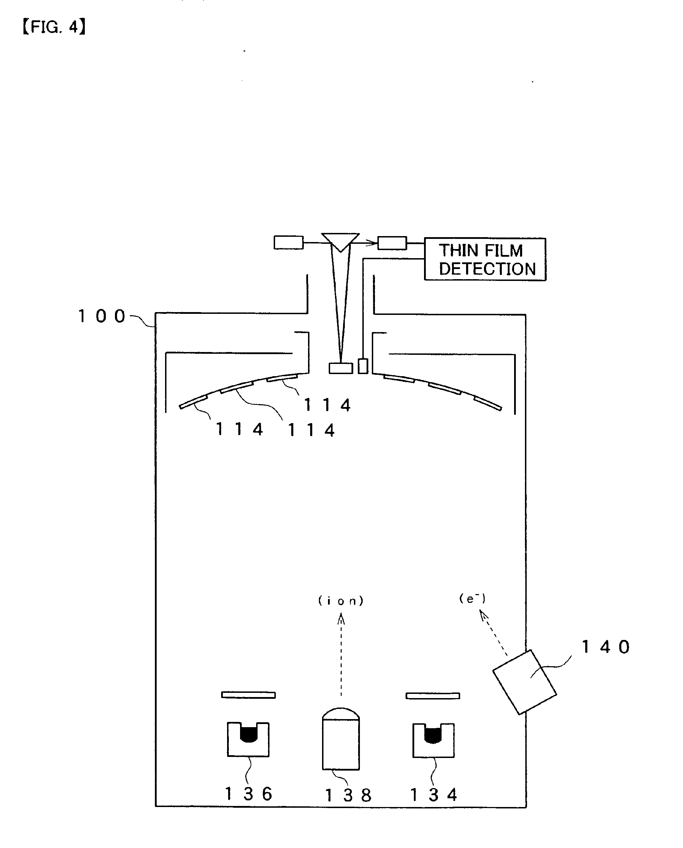

In techniques shown in Patent Documents 1, 2, as shown in Fig. 4, a high refractive material and a low refractive material are alternately evaporated and laminated from a plurality of evaporation sources 134, 136, so that antireflection layers formed by multi-layer films can be obtained. In such techniques, at the time of film formation of the high refractive material and the low refractive material respectively, evaporation materials adhered to substrates 114 are densified by argon ions and oxygen ions irradiated from an ion gun 138, and electrification of the substrates and the like are prevented by neutral electrons irradiated by a neutralizer 140.

Meanwhile, Patent Document 3 discloses a deposition apparatus for controlling a path of a plasma beam generated by a plasma gun with a magnetic field so as to irradiate the plasma beam to film formation materials and heat the film formation materials, and evaporating the film formation materials toward substrates.
In such a deposition apparatus, a deposition preventing plate around the substrates attached to this deposition apparatus is in an electrically floating state (floating) from a vacuum chamber grounded on the earth. By such an electrically floating state of the deposition preventing plate, the deposition preventing plate is electrified, so that adhesion of the film formation materials to a wall surface of the vacuum chamber is suppressed.

Patent Document 1: Japanese Patent Application Publication No. 1998(H10)-123301
Patent Document 2: Japanese Patent Application Publication No. 2007-248828
Patent Document 3: Japanese Patent Application Publication No. 2000-017429
JP2005-344131 discloses (abstract) a deposition apparatus, comprising a grounded vacuum chamber, a substrate holder (5), deposition means (3a, 3b) and an electrically floating inner wall (7). A plasma gun (2) is further provided.

### Disclosure of the Invention

### Problems to be Solved by the Invention

However, it is known that according to the technique shown in Patent Document 1 or 2, since the film formation materials are adhered on the inner surface side of the vacuum chamber and electrified at the time of the film formation, a potential structure in the vacuum chamber is changed, and in accordance with the change, film formation conditions such as an irradiation range of the ions are temporarily changed. Therefore, there is a need for performing a preliminary film formation process (test batch) until the film formation materials are uniformly adhered on the inner surface side of the vacuum chamber and the film formation conditions are stabilized, and there is a problem that productivity is lowered.

Since the ion gun and the neutralizer are arranged relatively close to each other, there is a phenomenon that, before a part of the ions irradiated from the ion gun reaches the substrate, the electrons irradiated from the neutralizer and the ions irradiated from the ion gun are reacted with each other and neutralized. This phenomenon that the ions passing through an area close to the neutralizer are neutralized is one of causes of the bias of the potential structure in the vacuum chamber and the change in the irradiation range of the ions. Further, since the ions are neutralized before reaching the substrate, the neutralized ions and the electrons cannot be effectually utilized.

Further, there is a fear that the biases of the potential structure in the vacuum chamber and the irradiation range of the ions become a cause of an adverse impact on the temporal change in the film formation conditions, conditions until the film formation materials are uniformly adhered on the inner surface side of the vacuum chamber, and the like.
Along with the change in the irradiation range of the ions collided with the wall surface of the vacuum chamber, adhesion articles adhered to the wall surface are increasingly exfoliated and scattered. Thus, there is a fear that foreign substances adhered to the substrate are increased.

It should be noted that according to the technique of Patent Document 3, the temporal change in the film formation conditions can be suppressed to some extent. However, in such a deposition apparatus provided with the ion gun and the neutralizer, a sufficient effect cannot be obtained for the above problem due to the fact that the ion gun and the neutralizer are arranged close to each other.

In consideration with the above problems, an object of the present invention is to provide a deposition apparatus provided with an ion gun and a neutralizer, the deposition apparatus capable of suppressing the temporal change in the film formation conditions.
Another object of the present invention is to provide a deposition apparatus capable of manufacturing an optical filter with high precision while reducing manufacturing cost of the optical filter.

### Means for Solving the Problems

The above problems are solved by a deposition apparatus of claim 1, including a vacuum chamber grounded on the earth, a substrate holder supported in the vacuum chamber, a substrate capable of being held by the substrate holder, a deposition means placed distant from the substrate by a predetermined distance so as to face the substrate, an ion gun for irradiating ions to the substrate, and a neutralizer for irradiating electrons to the substrate, wherein the vacuum chamber is provided with an inner wall electrically floating, the neutralizer is arranged on the side surface side of the vacuum chamber, the ion gun is arranged on the opposite side to the side where the substrate holder is arranged inside the vacuum chamber so that an ion irradiation port faces the substrate, and the neutralizer and the ion gun are arranged so as to be distant from each other by a predetermined distance.

In such a way, the deposition apparatus according to the present invention is provided with the ion gun for irradiating the ions to the substrate and the neutralizer for irradiating the electrons to the substrate. In addition, a structure provided with the inner wall electrically floating is employed.
Therefore, even when a state of the inner wall is temporarily changed due to adhesion of film formation materials to the inner wall of the vacuum chamber at the time of film formation, a change in a potential structure can be suppressed.
The neutralizer is arranged at a position distant from the ion gun on the side surface side of the vacuum chamber. Thus, reaction and neutralization of the ions irradiated from the ion gun and the electrons irradiated from the neutralizer before reaching the substrate can be suppressed.
Therefore, there is no loss of the ions irradiated from the ion gun and the electrons irradiated from the neutralizer, and biases of the potential structure in the vacuum chamber and an irradiation range of the ions are not generated. Thus, a temporal change in film formation conditions can be suppressed, so that the deposition apparatus without need for performing a preliminary film formation process with high productivity can be provided.

Specifically and preferably, as in claim 2, an opening area is formed in the inner wall, and the neutralizer is arranged on the inner side of the opening area without electric contact with the inner wall.
In such a way, the neutralizer according to the present invention is arranged on the inner side of the opening area of the inner wall electrically floating, without electric contact with the inner wall. Therefore, while maintaining a floating state of the inner wall, the neutralizer can be arranged at the position distant from the ion gun by an arbitrary distance. Thus, there is no loss of the ions irradiated from the ion gun and the electrons irradiated from the neutralizer, and the biases of the potential structure in the vacuum chamber and the irradiation range of the ions can be suppressed. Consequently, the temporal change in the film formation conditions can be more effectively prevented.

Further specifically and further preferably, as in claim 3, the neutralizer is arranged on the inner side of an opening area formed in the inner wall without electric contact with the inner wall, and an inner surface of the inner wall has a coating of insulating ceramic.
In such a way, the inner surface of the inner wall electrically floating has the coating of the insulating ceramic. Thus, even when insulating film formation materials are partly adhered to the surface of the inner wall, the change in the potential structure can be effectually suppressed.

Preferably, as in claim 4, an irradiated ion guide member for regulating an irradiation range of the ions is provided at a position from an ion irradiation port of the ion gun toward the substrate holder, and the irradiated ion guide member is arranged so as to reduce a diffusion range of the ions irradiated from the ion irradiation port, and electrically floating.
In such a way, since the irradiated ion guide member electrically floating is arranged on the side of the ion irradiation port of the ion gun, the ions can be guided in the direction of acting repulsively against the irradiated ion guide member. That is, since a surface of the irradiated ion guide member on the side of ion passage is electrified with the same electric charge as the ions in accordance with irradiation of the ions, the ions following and passing through this part receive repulsive force, and the ions are guided by this repulsive force.
In such a way, due to existence of the irradiated ion guide member, the irradiation range of the ions can be regulated and a change in the irradiation range can be suppressed, so that the ions collided with a wall surface on the inner side of the vacuum chamber can be reduced. Thus, since foreign substances adhered to the substrate can be reduced, an optical filter with high precision can be manufactured.

Further, preferably, as in claim 5, an irradiated electron guide member for regulating an irradiation range of the electrons is provided at a position from an electron irradiation port of the neutralizer toward the substrate holder, and the irradiated electron guide member is arranged so as to reduce a diffusion range of the electrons irradiated from the electron irradiation port, and electrically floating.
In such a way, since the irradiated electron guide member electrically floating is arranged on the side of the electron irradiation port of the neutralizer, the electrons can be guided in the direction of acting repulsively against the irradiated electron guide member. That is, since a surface of the irradiated electron guide member on the side of electron passage is electrified with the same electric charge as the electrons in accordance with irradiation of the electrons, the electrons following and passing through this part receive repulsive force, and the electrons are guided by this repulsive force.
In such a way, due to existence of the irradiated electron guide member, the electrons can be precisely irradiated to a desired area. Thus, an amount of the ions reacted with and neutralized by the electrons before reaching the substrate can be reduced. Therefore, the bias of the potential structure in the vacuum chamber and the change in the irradiation range of the ions can be effectually suppressed. Thus, the temporal change in the film formation conditions can be effectively prevented.

Specifically and preferably, as in claim 6, an irradiated ion guide member electrically floating for regulating an irradiation range of the ions is provided at a position from an ion irradiation port of the ion gun toward the substrate holder, an irradiated electron guide member electrically floating for regulating an irradiation range of the electrons is provided at a position from an electron irradiation port of the neutralizer toward the substrate holder, and at least one of the irradiated ion guide member and the irradiated electron guide member is formed into a tubular shape.
In such a way, since at least one of the irradiated ion guide member and the irradiated electron guide member is formed into a tubular shape, the ions or the electrons are precisely irradiated from an opening part on one end of the irradiated ion guide member and the irradiated electron guide member toward the irradiation direction. Therefore, the foreign substances adhered to the substrate can be reduced, and the change in the irradiation range of the ions and the like can be more effectively suppressed.

The above problems are solved by a manufacturing method of a thin film device of claim 7 using a deposition apparatus including a vacuum chamber grounded on the earth and provided with an inner wall electrically floating, a substrate holder supported in the vacuum chamber, a substrate capable of being held by the substrate holder, a deposition means placed distant from the substrate by a predetermined distance so as to face the substrate, an ion gun arranged on the opposite side to the side where the substrate holder is arranged inside the vacuum chamber so that an ion irradiation port faces the substrate, the ion gun for irradiating ions to the substrate, a neutralizer arranged on the side surface side of the vacuum chamber, the neutralizer for irradiating electrons to the substrate, and shutters respectively arranged in the immediate vicinity of a deposition material irradiation port of the deposition means and an ion irradiation port of the ion gun, the manufacturing method, including an arrangement step of arranging the substrate in the substrate holder, a setting step of rotating the substrate holder by the predetermined rotation number, setting pressure in the vacuum chamber to a predetermined value, and increasing a temperature of the substrate to a predetermined value, a preparation step of making the ion gun and the deposition means an idling state, and a deposition step of irradiating the deposition material to the substrate by opening the shutters, wherein in the deposition step, electrons are irradiated from the neutralizer arranged close to the substrate holder so as to be distant from the ion gun by a predetermined distance toward the substrate.
In such a way, according to the present invention, manufacture of a thin film device in which the conventional problems are solved can be performed by the deposition apparatus effectually having the effects described in claims 1 to 6, and the thin film device manufactured by the present method with this deposition apparatus has an excellent characteristic even with relatively low manufacturing cost.

### Effect of the Invention

According to the deposition apparatus of claim 1, even when the state of the inner wall is temporarily changed due to the adhesion of the film formation materials to the inner wall of the vacuum chamber at the time of the film formation, the change in the potential structure can be suppressed, and there is no loss of the ions irradiated from the ion gun and the electrons irradiated from the neutralizer. Therefore, the manufacturing cost of the optical filter can be reduced.
In the deposition apparatus of claim 2, since the neutralizer is arranged at the position distant from the ion gun by an arbitrary distance, there is no loss of the ions irradiated from the ion gun and the electrons irradiated from the neutralizer.
Further, according to the deposition apparatus of the claim 3, the inner surface of the inner wall electrically floating has the coating of the insulating ceramic. Thus, even when the insulating film formation materials are partly adhered to the surface of the inner wall at the time of the film formation, the change in the potential structure can be suppressed.
According to the deposition apparatus of claim 4, by reducing the ions collided with the wall surface of the vacuum chamber, the foreign substances adhered to the substrate are reduced, so that the optical filter with high precision can be manufactured.
Further, according to the deposition apparatus of claim 5, the bias of the potential structure in the vacuum chamber and the change in the irradiation range of the ions can be suppressed, so that the temporal change in the film formation conditions can be effectively prevented.
According to the deposition apparatus of claim 6, since the irradiation can be precisely performed toward the irradiation direction, the foreign substances adhered to the substrate can be reduced, and the change in the irradiation range of the ions and the like can be more effectively suppressed.
Further, according to the manufacturing method of the thin film device of claim 7, the thin film device having an excellent characteristic can be manufactured.

### Brief Description of the Drawings

[Fig. 1] A concept diagram of a deposition apparatus according to a first embodiment of the present invention.
[Fig. 2] A graph showing transmittance of optical filters of Example 1 and Comparative Example 1.
[Fig. 3] A concept diagram of a deposition apparatus according to a second embodiment of the present invention.
[Fig. 4] A concept diagram of a conventional deposition apparatus.

### Explanation of Reference Characters

1, 2: Deposition apparatus
10, 100: Vacuum chamber
12: Substrate holder
14, 114: Substrate
18: Crystal monitor
19: Film thickness detection portion
30: Inner wall
31: Opening area
34, 36, 134, 136: Evaporation source
34a, 36a, 38a: Shutter
38, 138: Ion gun
40, 140: Neutralizer
50: Irradiated ion guide member
52: Irradiated electron guide member
T: Transmittance λ : Wavelength

### Best Modes for Carrying out the Invention

Hereinafter, one embodiment of the present invention will be described with reference to the drawings. It should be noted that members, arrangement and the like described below are only one example embodying the invention, and the present invention is not limited thereto. As a matter of course, the members, the arrangement and the like can be variously modified along the gist of the present invention.

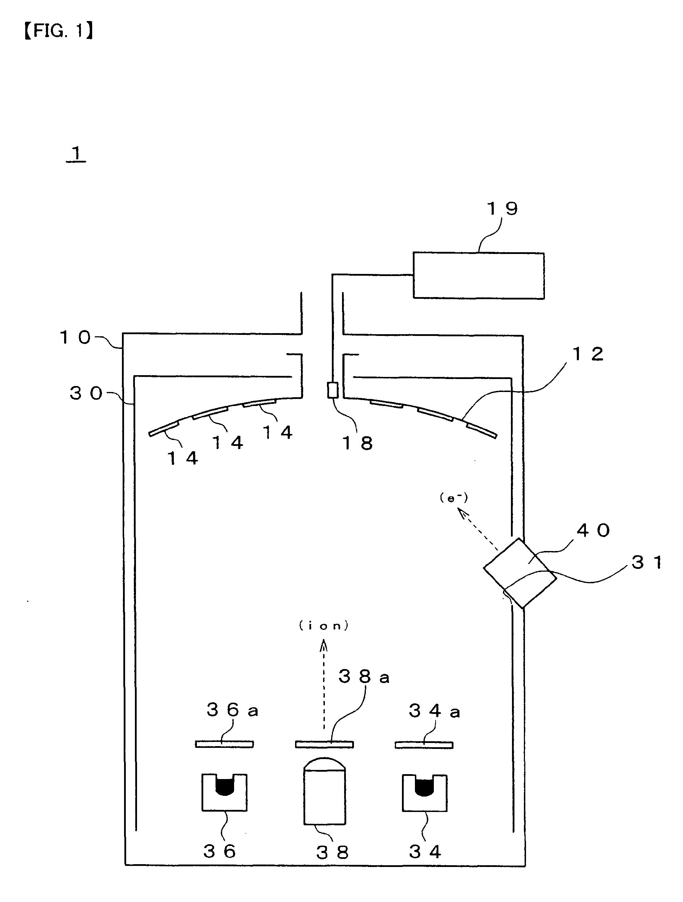

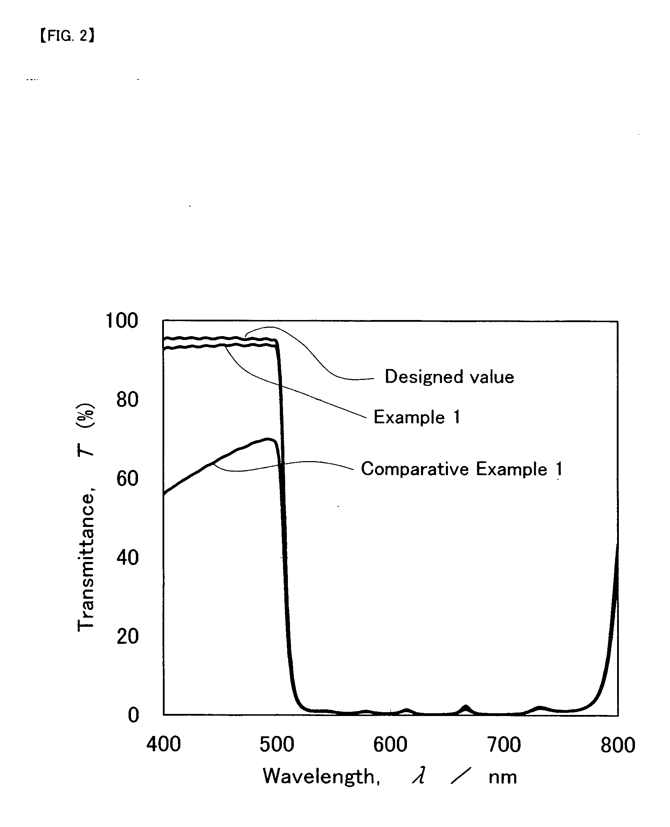

Figs. 1 and 2 show a first embodiment of the present invention. Fig. 1 is a concept diagram of a deposition apparatus, and Fig. 2 is a graph showing transmittance of optical filters of Example 1 and Comparative Example 1.

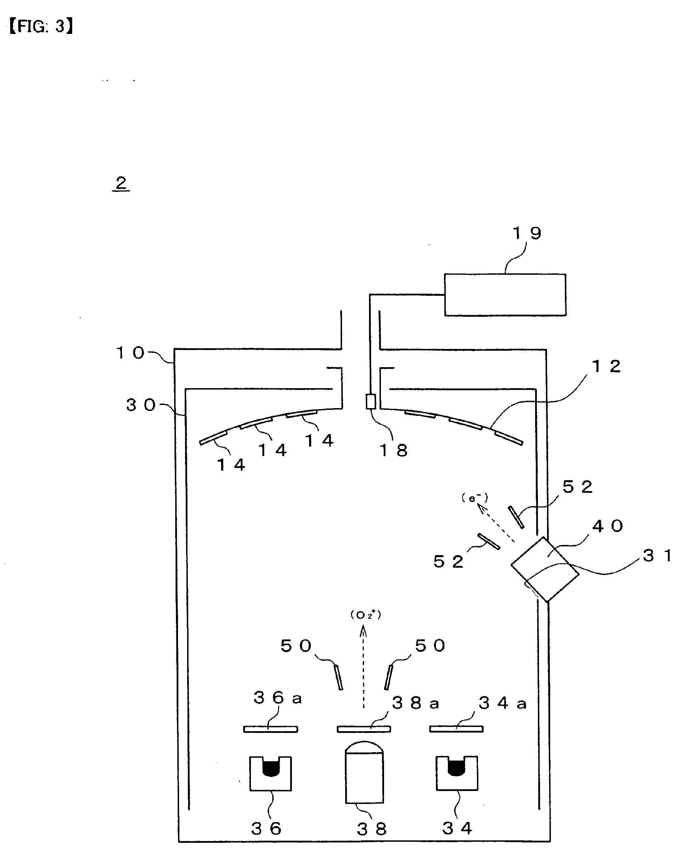

Fig. 3 is a concept diagram of a deposition apparatus according to a second embodiment.

### (First Embodiment)

A configuration of a deposition apparatus 1 according to the first embodiment of the present invention will be described with Fig. 1.
Fig. 1 is the concept diagram of the deposition apparatus 1 according to the first embodiment.
The deposition apparatus 1 according to the present embodiment mainly includes a vacuum chamber 10, a substrate holder 12, evaporation sources 34, 36, an ion gun 38, and a neutralizer 40.

The vacuum chamber 10 according to the present embodiment is a stainless container normally used in a known film formation device, which is a cylindrical member to be vertically mounted and grounded on the earth so as to have ground potential.
An inner wall 30 provided on the inner side of this vacuum chamber 10 is a substantially cylindrical member arranged along a side surface and an upper surface on the inner side of the vacuum chamber 10, which is electrically floating. The inner wall is arranged so as to surround the upper side and a side surface in the circumferential direction of the substrate holder 12 described below.
This inner wall 30 is fixed to an inner surface of the vacuum chamber 10 having the ground potential via an insulating member (not shown) such as an insulator. In such a way, by insulating the inner wall from the vacuum chamber 10, a floating process of the inner wall 30 is performed.
It should be noted that the inner wall 30 is made of a stainless member as well as the vacuum chamber 10, and a ceramic sheet (not shown) having a coating of ceramic such as silica is adhered to an inner surface thereof.

Further, an opening area 31 is provided in side surface parts of the vacuum chamber 10 and the inner wall 30 so that the interior and the exterior communicate with each other. The neutralizer 40 described below is arranged in this opening area 31.
In the present embodiment, the opening area 31 is formed into a hole shape surrounded by the inner wall 30.
However, a shape of the opening area 31 may be a cut-out shape formed by cutting part of a lower part of the inner wall 30. Although the opening area 31 is formed on the side surface side of the vacuum chamber 10, the opening area can be provided at an arbitrary position.
It should be noted that the inside of this vacuum chamber 10 is exhausted so that pressure thereof becomes predetermined pressure (such as about 3 x 10⁻² to 10⁻⁴ Pa) by an exhaust means (not shown).

The substrate holder 12 according to the present embodiment is a stainless member formed into a dome shape (a substantially semi-spherical shape), which is held on the upper side in the vacuum chamber 10 rotatably around a vertical axis.
This substrate holder 12 is coaxially connected to an output shaft of a motor (not shown).
A large number of substrates 14 are fixed to a lower surface of the substrate holder 12 so that film formation surfaces thereof are directed downward.

Further, the substrate holder 12 is supported on the output shaft of the motor (not shown) (fixed on the outer side of the vacuum chamber 10) via an insulating material (not shown) such as an insulator, and electrically floating.
A film thickness detection device is arranged in a hole portion provided in a center of the substrate holder 12. In the present embodiment, a known crystal monitor 18 is provided as the film thickness detection device. The crystal monitor 18 detects physical film thickness from a change in a resonance frequency due to adhesion of a thin film on a surface thereof with a film thickness detection portion 19.

The substrates 14 installed in this substrate holder 12 are made of a material having light transmittance, and dielectric films or absorption films are adhered to surfaces thereof by deposition. Although the disc shaped substrates 14 are used in the present embodiment, a shape of the substrates is not limited to this. The substrates may be formed into the other shapes such as a lens shape, a cylindrical shape and an annular shape as long as thin films can be formed on the surfaces.

The evaporation sources 34, 36 according to the present embodiment are devices for heating and evaporating a high refractive material and a low refractive material by an electronic beam heating method, which are arranged on the lower side in the vacuum chamber 10.
In the present embodiment, the evaporation source 34 is formed as an evaporation means of the high refractive material, and the evaporation source 36 is formed as an evaporation means of the low refractive material.
On the upper side of the evaporation sources 34, 36 and the ion gun 38 described below, openable and closable shutters 34a, 36a, 38a are attached. These shutters 34a, 36a, 38a are appropriately controlled to open and close by a controller (not shown).

It should be noted that, although the film formation is performed by alternately laminating the high refractive material and the low refractive material for an optical filter in which the film formation is performed in the present embodiment, the present invention is applicable to the film formation of the optical filter including one kind or plural kinds of evaporation materials. In that case, the number and arrangement of the evaporation source can be appropriately changed.
Further, as a specific example of the optical filter manufactured in the present embodiment, a short wave pass filter (SWPF) is provided. However, in addition to this, the present invention is applicable to a thin film device such as a long wave pass filter, bandpass filter and a ND filter.

The ion gun 38 according to the present embodiment is a device for emitting ions (ion) toward the substrates 14, which takes out electrified ions (O₂⁺, Ar⁺) from a plasma of a reactive gas (such as O₂) and a rare gas (such as Ar), accelerates the ions with an accelerating voltage, and injects the ions.

The neutralizer 40 is to emit electrons (e⁻) toward the substrates 14, for taking out the electrons from the plasma of the rare gas such as Ar, accelerating the electrons with the accelerating voltage, and injecting the electrons. The electrons emitted from the neutralizer neutralize the ions adhered to the surfaces of the substrates 14.
In the deposition apparatus 1 according to the present embodiment, the neutralizer 40 is arranged at a position distant from the ion gun 38.

Specifically, the neutralizer 40 is directly attached to the side surface of the vacuum chamber 10 so as to pass through the opening area 31 provided in the inner wall 30. At this time, the neutralizer 40 is not in direct contact with the inner wall 30.
An arrangement position of this neutralizer 40 is designed to be a position more distant from the ion gun 38 than an arrangement position of a conventional apparatus of this type, and also designed to be a position more close to an arrangement position of the substrate holder 12.
Further, by arranging the neutralizer 40 on the inner side of the opening area 31 without contact with the inner wall, the neutralizer 40 can be arranged at the position distant from the ion gun 38 by an arbitrary distance while maintaining a floating state of the inner wall 30. Thus, losses of the ions irradiated from the ion gun 38 and the electrons irradiated from the neutralizer 40 are prevented, and biases of a potential structure in the vacuum chamber 10 and an irradiation range of the ions can be suppressed.
It should be noted that although the opening area 31 is formed into a hole shape surrounded by the inner wall 30 in the present embodiment as described above, the opening area may be formed into a cut-out shape formed by cutting part of the lower part of the inner wall 30. Although the opening area 31 is formed on the side surface side of the vacuum chamber 10, the opening area can be provided at an arbitrary position.

As described above, the deposition apparatus 1 according to the present embodiment mainly includes the vacuum chamber 10, the substrate holder 12, the evaporation sources 34, 36, the ion gun 38, and the neutralizer 40.
Arrangement of the above members will be described. Firstly, the substrate holder 12 is held on the upper side in the vertically mounted cylindrical vacuum chamber 10, and the evaporation sources 34, 36 and the ion gun 38 are arranged on the lower side in the vacuum chamber 10. The neutralizer 40 is arranged on the side surface side in the vacuum chamber 10 so as to pass through the opening area 31.
Further, the ion gun 38 is arranged between the evaporation sources 34, 36, and the shutters 34a, 36a, 38a are attached on the injection port side of the evaporation sources 34, 36 and the ion gun 38 (the side where the surfaces of the substrates 14 held by the substrate holder 12 are arranged).

Hereinafter, operation of this deposition apparatus 1 will be described.
Firstly, the substrates 14 are set in the substrate holder 12 in the vacuum chamber 10, and the inside of the vacuum chamber 10 is exhausted so as to have predetermined pressure.
The substrate holder 12 is rotated by the predetermined rotation number, and a temperature of the substrates 14 is increased to a predetermined temperature by an electric heater (not shown).
Next, an ion source of the ion gun 38 is made to be an idling state capable of immediately irradiating the ions. At the same time, the evaporation sources 34, 36 are made to be a state capable of immediately emitting evaporation particles (that is, by opening the shutters 34a, 36a, the evaporation particles get ready for being immediately emitted).
After confirming that the rotation number of the substrate holder 12 and the temperature of the substrates 14 reach predetermined conditions by performing such operation, an evaporation step is executed.

In the evaporation step, opening and closing of the shutters of the evaporation source 34 for emitting the high refractive material (such as Ta₂O₅ and TiO₂) and the evaporation source 36 for emitting the low refractive material (such as SiO₂) are controlled, so that the high refractive material and the low refractive material are alternately emitted toward the substrates 14. While emitting these deposition materials, the shutter 38a of the ion gun 38 is opened and the emitted ions (such as O₂⁺) are collided with the substrates 14, so that the deposition materials adhered to the substrates 14 are densified. By repeating this operation for predetermined times, multi-layer films are formed.

In general, a bias of an electric charge is generated in the substrate holder 12 due to the irradiation of the ions. However, in the deposition apparatus 1, the bias of the electric charge of this substrate holder 12 is neutralized by irradiating the electrons from the neutralizer 40 toward the substrate holder 12.
By arranging the neutralizer 40 at the position close to the substrate holder 12, the electrons can be precisely irradiated toward an area of the substrate holder 12 where the ions irradiated from the ion gun 38 are adhered.
Further, since the neutralizer 40 is arranged at the position distant from the ion gun 38, the ions moving from the ion gun 38 toward the substrates 14 and the electrons emitted from the neutralizer 40 are not often directly reacted with each other. Thus, the electric charge of the substrate holder 12 can be efficiently neutralized. Therefore, even when a current value to be applied to the neutralizer 40 is lower than the conventional evaporation apparatus, the substrate holder 12 can be rightly neutralized.
Specifically, even when a current value (an ion current) to be applied to the ion gun 38 which is required for electrically neutralizing the substrate holder 12 and the current value (a neutralizer current) to be applied to the neutralizer 40 are the substantially same, the optical filter can be rightly manufactured.

Since the inner wall 30 is electrically floating, a phenomenon that film formation conditions are temporarily changed is solved. Particularly, there is an effect of preventing the temporal change in the film formation conditions after performing chamber maintenance such as cleaning of the inside of the vacuum chamber 10.
Further, since the inner wall 30 is arranged so as to surround the upper side and the side surface side of the substrate holder 12, a change in the potential structure can be prevented over the entire surfaces on the inner side.

It should be noted that by adhering the ceramic sheet on the inner side of the inner wall 30, an effect of increasing an insulating property of the inner wall 30 and further reducing the change in the potential state in the inner wall 30 and the vacuum chamber 10 to which the deposition materials having an insulating property are partly adhered can be expected.
However, the ceramic sheet is not necessarily used. Also in this case, since the inner wall 30 is processed so as to be electrically floating, the change in the potential structure due to the adhesion of the deposition materials to the inner wall 30 can be suppressed within a small range.

An impact of the floating of the inner wall 30 on a film formation step will be examined.
In the conventional deposition apparatus (refer to Fig. 4), when the insulating deposition materials adhered to an inner surface of a vacuum chamber (a chamber inner wall) are removed by maintenance of the deposition apparatus (chamber maintenance), the chamber inner wall is conducted to a chamber main body so as to have ground potential after the chamber maintenance.
Therefore, in film formation after the maintenance, the electrons are absorbed by the chamber inner wall.
Meanwhile, in order to completely oxidize dielectric films such as a high refractive film and a low refractive film, there is a need for sufficiently supplying not only the oxygen ions (O₂⁺) but also the electrons (e⁻). When the chamber inner wall is conducted to the chamber main body, the dielectric films on the substrates cannot receive sufficient electrons so as not to be completely oxidized.
Since the insulating evaporation materials are adhered to the chamber inner wall by performing the film formation, the potential structure in the vacuum chamber is gradually changed.

As in the deposition apparatus 1 according to the present embodiment (refer to Fig. 1), by doubling the inner side of the vacuum chamber 10 and floating the inner wall 30, the inner wall 30 is not conducted to the vacuum chamber 10 even after the chamber maintenance. Therefore, gradual change of the potential structure in the vacuum chamber 10 is prevented, so that stable film formation can be performed immediately after the chamber maintenance.
Therefore, there is no need for performing test batch (film formation performed until the potential state of the chamber inner wall is stabilized after performing the chamber maintenance) which is conventionally performed in film formation by an ion assist deposition method.

Conventionally, the crystal monitor 18 and a known optical monitor are both provided as the film thickness detection device, so that the film thickness is measured. However, with the deposition apparatus 1 according to the present embodiment, the potential structure in the vacuum chamber 10 is not changed even after the chamber maintenance, so that the temporal change in the film formation conditions, particularly the change in the irradiation range of the ions irradiated from the ion gun 38 is not generated. Thus, film formation speed is stabilized, and film thickness measurement with high precision can be performed even by film thickness measurement only with the crystal monitor 18.

### (Example 1)

Example 1 in which the film formation is performed using the deposition apparatus 1 shown in Fig. 1 will be described in comparison to Comparative Example 1 in which the film formation is performed with the conventional deposition apparatus (refer to Fig. 4).
In both Example 1 and Comparative Example 1, Ta₂O₅ is used as the high refractive material and SiO₂ is used as the low refractive material and multi-layer films of a short wave pass filter (SWPF) including 37 layers (total film thickness: 3,300 nm) are deposited in a first batch after the chamber maintenance.
Fig. 2 shows measurement results of optical characteristics of the manufactured SWPF multi-layer films.

Film formation conditions of Example 1 are as follows.
Substrate: BK7 (refractive index n = 1.52)
Temperature of substrate: 150°C
Film material: Ta₂O₅ (high refractive film), SiO₂ (low refractive film)
Deposition speed of Ta₂O₅: 0.7 nm/sec
Deposition speed of SiO₂: 1.0 nm/sec
Ion gun conditions upon evaporation of Ta₂O₅
Introduced gas: 60 sccm of oxygen
Accelerating voltage of ion: 1,000 V
Ion current: 1,200 mA
Ion gun conditions upon evaporation of SiO₂
Introduced gas: 60 sccm of oxygen
Accelerating voltage of ion: 1,000 V
Ion current: 1,200 mA
Neutralizer conditions
Accelerating voltage: 30 V
Neutralizer current: 1,200 mA
Discharge gas: 10 sccm of argon

Film formation conditions of Comparative Example 1 are as follows. In comparison to Example 1, a value of the neutralizer current is different.
Substrate: BK7 (refractive index n = 1.52)
Temperature of substrate: 150°C
Film material: Ta₂O₅ (high refractive film), SiO₂ (low refractive film)
Deposition speed of Ta₂O₅: 0.7 nm/sec
Deposition speed of SiO₂: 1.0 nm/sec
Ion gun conditions upon evaporation of Ta₂O₅
Introduced gas: 60 sccm of oxygen
Accelerating voltage of ion: 1,000 V
Ion current: 1,200 mA
Ion gun conditions upon evaporation of SiO₂
Introduced gas: 60 sccm of oxygen
Accelerating voltage of ion: 1,000 V
Ion current: 1,200 mA
Neutralizer conditions
Accelerating voltage: 30 V
Neutralizer current: 2,000 mA
Discharge gas: 10 sccm of argon

Fig. 2 shows measurement values of the optical characteristics of the SWPF multi-layer films manufactured in Example 1 and Comparative Example 1.
Fig. 2 is the graph showing the transmittance of the optical filters of Example 1 and Comparative Example 1. A wavelength λ in a visible light region from 400 to 800 nm is irradiated to the manufactured SWPF multi-layer films, and transmittance T thereof is plotted in the graph relative to the wavelength λ.
According to Fig. 2, the multi-layer films manufactured in Example 1 within a range of the wavelength λ from 400 to 500 nm have a higher value of the transmittance T than the multi-layer films in Comparative Example 1.

Specifically, with the transmittance T of the wavelength λ = 500 nm, compared to a designed value of 94.8%, the transmittance T of the multi-layer films in Comparative Example 1 is 68.7%, and the transmittance T of the multi-layer films in Example 1 is 93.3%. With the transmittance T of the wavelength λ = 400 nm, compared to the designed value of 95.1%, the transmittance T of the multi-layer films in Comparative Example 1 is 55.9%, and the transmittance T of the multi-layer films in Example 1 is 92.6%.

In such a way, in the film formation in the first batch after the chamber maintenance, in comparison to the SWPF multi-layer films manufactured by the conventional apparatus (Comparative Example 1), with the SWPF multi-layer films manufactured by the deposition apparatus 1 according to the present invention (Example 1), the transmittance T is remarkably improved in the range of the wavelength λ from 400 to 500 nm, and a substantially flat transmittance characteristic is given in this wavelength region.
Further, within a range of the wavelength λ from 520 to 780 nm, a change in the transmittance T is not found, and the transmittance is almost zero in both Example 1 and Comparative Example 1.

It is examined that the improvement of the transmittance T due to the floating of the inner wall 30 for the electric insulation is based on the following reasons.
The floating of the inner wall 30 of the vacuum chamber 10 reduces an amount of the electrons absorbed from the inner wall 30 after the maintenance. Therefore, sufficient electrons are supplied to the surfaces of the substrates 14, so that the dielectric films such as the high refractive film and the low refractive film can be completely oxidized. Thus, uniformity of the deposited structures is improved. In such a way, since the formed film structures have favorable uniformity, stable films with a reduced change in the refractive index and not more than a fixed value of a light absorption coefficient can be obtained.

It should be noted that even when the substrate holder 12 is not electrically floating in Example 1, the optical characteristic of the SWPF multi-layer films deposited in the first batch after the chamber maintenance has the substantially same result as in Example 1 described above.
This is thought to be because the floating of the inner wall 30 has a greater impact on the film conditions than the floating of the substrate holder 12.

### (Second Embodiment)

Fig. 3 is the concept diagram of a deposition apparatus 2 according to the second embodiment of the present invention.
It should be noted that in the following embodiment, the same members, arrangement and the like as the first embodiment will be given the same reference characters, and detailed description thereof will be omitted.
In the deposition apparatus 2 according to the present embodiment, an irradiated ion guide member 50 and an irradiated electron guide member 52 are attached to the deposition apparatus 1 according to the first embodiment.

The irradiated ion guide member 50 according to the present embodiment is a stainless member formed into a substantially tubular shape, more specifically a trumpet shape, which is arranged in the vicinity of an ion injection port of the ion gun 38 and formed so that opening width of an end on the side apart from the ion gun 38 is larger. The irradiated ion guide member 50 is attached on the lower surface side of the vacuum chamber 10 via an attachment jig and an insulator and electrically floating. The irradiated ion guide member is arranged so that the ions irradiated from the ion gun 38 pass through a tubular part of the irradiated ion guide member 50.

The irradiated electron guide member 52 according to the present embodiment is a stainless member formed into a substantially tubular shape, which is arranged in the vicinity of an electron injection port of the neutralizer 40 and formed so as to have a similar shape to the irradiated ion guide member 50 described above. The irradiated electron guide member is arranged so that the electrons irradiated from the neutralizer 40 pass through a tubular part of the irradiated electron guide member 52. The irradiated electron guide member is attached to the vacuum chamber 10 via an attachment jig and an insulator and electrically floating.

Effects of the irradiated ion guide member 50 will be described.
When the ions are irradiated from the ion gun 38 and pass through the inside of the irradiated ion guide member 50, the inside is electrified in accordance with the electric charge of the ions. In the present embodiment, since O₂⁺ is used as the ions, the inside of the irradiated ion guide member 50 is positively electrified.
Therefore, O₂⁺ irradiated from the ion gun 38 is reacted with the inner surface of the irradiated ion guide member 50 which is positively electrified and guided in the opening direction of the irradiated ion guide member 50.
In such a way, the ions emitted in the desired direction are increased, whereas the ions undesirably collided with the wall surface of the chamber such as the inner wall 30 are reduced. Therefore, scatter of adhesion articles adhered to the wall surface due to the ion collisions and adhesion of the adhesion articles to the substrates 14 as foreign substances can be suppressed.

The irradiated ion guide member 50 has an effect of increasing density of the ions irradiated form the ion gun 38.
This is because the ions reflect the members electrified by the floating process so as to be guided to an opening part of the irradiated ion guide member 50. That is, with the deposition apparatus of which a conventional irradiated ion guide member 50 is replaced, ions can be emitted in the desired direction and accordingly the density of the irradiated ions can be increased, instead of irradiation and scattering of ions in the peripheral directions.

In such a way, since the density of the ions irradiated through the irradiated ion guide member 50 is increased, the deposition materials adhered to the substrates 14 can be efficiently densified.
Therefore, an optical filter manufactured by the deposition apparatus 2 provided with the irradiated ion guide member 50 is densified and an optical characteristic thereof is improved. Specifically, an absorption rate of a visible ray incident on the optical filter is lowered, so that the optical filter with improved transmittance and high precision can be manufactured.
As a matter of course, a processing time can be shortened. In this case, productivity can be improved and cost can be reduced.

Next, effects of the irradiated electron guide member 52 will be described.
When the electrons irradiated from the neutralizer 40 pass through the inside of the tubular irradiated electron guide member 52, the inside is negatively electrified. Therefore, the electrons irradiated from the neutralizer 40 act repulsively against an inner surface of the irradiated electron guide member 52 which is negatively electrified as well as the electrons so as to be guided in the opening direction of the irradiated electron guide member 52.
In such a way, the electrons emitted in the desired direction are increased, whereas the electrons scattered away from the irradiation direction are reduced. Thus, consumption of the electrons for neutralization of the ions irradiated from the ion gun 38 toward the substrates 14, and consumption of the electrons for neutralization of the electric charge of the irradiated ion guide member 50 can be suppressed. That is, by providing the irradiated electron guide member 52, the ion gun 38 and the irradiated ion guide member 50 can be more efficiently used.

Since the deposition apparatus 2 described above is provided with the irradiated ion guide member 50 and the irradiated electron guide member 52, the deposition materials adhered to the substrates 14 are densified, so that the optical filter with high transmittance can be manufactured, and the scatter of the foreign substances from the wall surface of the chamber due to the irradiation of the ions is prevented, so that failure in the film formation can be reduced. By providing the irradiated electron guide member 52, unnecessary neutralization of the ions irradiated from the ion gun 38 toward the substrates 14 and the electric charge of the irradiated ion guide member 50 can be prevented, so that the ion gun 38 and the irradiated ion guide member 50 can be more efficiently used.
As a matter of course, since the inner wall 30 of the vacuum chamber 10 is electrically floating as well as the deposition apparatus 1, the deposition apparatus 2 also has the effects of the deposition apparatus 1 according to the first embodiment. Thus, sufficient electrons are supplied to the surfaces of the substrates 14, so that the dielectric films such as the high refractive film and the low refractive film can be completely oxidized.

In the second embodiment described above, the irradiated ion guide member 50 is formed into a substantially tubular shape. However, the irradiated ion guide member may be formed into the other shapes, a hollow square columnar shape or a ring shape. The irradiated ion guide member may be formed as a plate shape (shutter shape) member (a shielding member) for partly shielding an upper part of the ion gun 38.
For example, when the irradiation port of the ion gun 38 is shielded by a predetermined rate with a plate shaped shielding member electrically floating, the ions cannot be collided with the shielding member electrified by the floating process but emitted from an unshielded opening part. Therefore, as well as the irradiated ion guide member 50 of the second embodiment, the density of the ions irradiated from the ion gun 38 can be improved. That is, by colliding the ions emitted from the irradiation port of the ion gun 38 which is partly shielded by the floating shielding member with the substrates 14, the deposition materials adhered to the substrates 14 can be efficiently densified. It should be noted that the rate of shielding the irradiation port of the ion gun 38 can be 10 to 70%, preferably about 30%.

In the present invention, the inner wall 30 is formed into a substantially cylindrical shape surrounding the circumference of the substrate holder 12. However, the inner wall may be formed into the other shapes as long as covering a range where the ions irradiated from the ion gun 38 are collided. For example, the inner wall may be formed as a plurality of plate shaped members arranged in the circumference of the substrate holder 12.
The inner wall 30 and the irradiated ion guide member 50 or the irradiated electron guide member 52 are made of stainless but may be made of the other materials such as an aluminum alloy and ceramic.

## Claims

1. A deposition apparatus, comprising:
a vacuum chamber (10,100) grounded on the earth;
a substrate holder (12) supported in the vacuum chamber;
a substrate capable of being held by the substrate holder;
a deposition means (34, 36) placed distant from the substrate by a predetermined distance so as to face the substrate;
an ion gun (38) for irradiating ions to the substrate; and
a neutralizer (40) for irradiating electrons to the substrate, wherein
the vacuum chamber is provided with an inner wall (30) electrically floating with respect to the vacuum chamber,
the neutralizer (40) is arranged on a side of the vacuum chamber,
the ion gun (38) is arranged on an opposite side to a side where the substrate holder (12) is arranged inside the vacuum chamber so that an ion irradiation port faces the substrate, and
the neutralizer and the ion gun are arranged so as to be distant from each other by a predetermined distance.

2. The deposition apparatus according to claim 1, wherein
an opening area is formed in the inner wall, and
the neutralizer is arranged on the inner side of the opening area without electric contact with the inner wall.

3. The deposition apparatus according to claim 1, wherein
the neutralizer is arranged on the inner side of an opening area formed in the inner wall without electric contact with the inner wall, and
an inner surface of the inner wall has a coating of insulating ceramic.

4. The deposition apparatus according to claim 1, wherein
an irradiated ion guide member (50) for regulating an irradiation range of the ions is provided between an ion irradiation port of the ion gun and the substrate holder, and
the irradiated ion guide member is arranged so as to reduce a diffusion range of the ions irradiated from the ion irradiation port, and which is electrically floating with respect to the vacuum chamber.

5. The deposition apparatus according to claim 1, wherein
an irradiated electron guide member (52) for regulating an irradiation range of the electrons is provided between an electron irradiation port of the neutralizer and the substrate holder, and
the irradiated electron guide member is arranged so as to reduce a diffusion range of the electrons irradiated from the electron irradiation port, and which is electrically floating with respect to the vacuum chamber.

6. The deposition apparatus according to claim 1, wherein
an irradiated ion guide member electrically floating with respect to the vacuum chamber for regulating an irradiation range of the ions is provided between an ion irradiation port of the ion gun and the substrate holder,
an irradiated electron guide member for regulating an irradiation range of the electrons, which is electrically floating with respect to the vacuum chamber is provided at between an electron irradiation port of the neutralizer and the substrate holder, and
at least one of the irradiated ion guide member and the irradiated electron guide member is formed into a tubular shape.

7. A manufacturing method of a thin film device using a deposition apparatus comprising:
a vacuum chamber (10, 100) grounded on the earth and provided with an inner wall, which is electrically floating with respect to the vacuum chamber;
a substrate holder (12) supported in the vacuum chamber;
a substrate capable of being held by the substrate holder;
a deposition means (34, 36) placed distant from the substrate by a predetermined distance so as to face the substrate;
an ion gun (38) for irradiating ions to the substrate, which is arranged on an opposite side to a side where the substrate holder is arranged inside the vacuum chamber so that an ion irradiation port faces the substrate;
a neutralizer (40) for irradiating electrons to the substrate, which is arranged on the side surface side of the vacuum chamber; and
a shutter (34a, 36a) arranged in an immediate vicinity of a deposition material irradiation port of the deposition means and an ion irradiation port of the ion gun,
the manufacturing method, comprising:
an arrangement step of arranging the substrate in the substrate holder;
a setting step of rotating the substrate holder by a predetermined rotation number, setting pressure in the vacuum chamber to a predetermined value, and increasing a temperature of the substrate to a predetermined value;
a preparation step of bringing the ion gun and the deposition means to an idling state; and
a deposition step of irradiating the deposition material to the substrate by opening the shutter, wherein
in the deposition step, electrons are irradiated from the neutralizer arranged close to the substrate holder so as to be distant from the ion gun by a predetermined distance toward the substrate.

## Patentansprüche

1. Abscheidevorrichtung, die umfasst:
eine Vakuumkammer (10, 100), die geerdet ist;
einen Substrat-Halter (12), der in der Vakuumkammer gelagert ist;
ein Substrat, das von dem Substrat-Halter gehalten werden kann;
eine Abscheideeinrichtung (34, 36), die um einen vorgegebenen Abstand von dem Substrat entfernt so angeordnet ist, dass sie dem Substrat zugewandt ist;
eine lonenquelle (38) zum Bestrahlen des Substrats mit Ionen; und
eine Neutralisationseinrichtung (40) zum Bestrahlen des Substrats mit Elektronen, wobei die Vakuumkammer mit einer Innenwand (30) versehen ist, die in Bezug auf die Vakuumkammer elektrisch potentialfrei ist,
wobei die Neutralisationseinrichtung (40) an einer Seite der Vakuumkammer angeordnet ist,
die Ionenquelle (38) an einer Seite angeordnet ist, die einer Seite gegenüberliegt, an der der Substrat-Halter (12) im Inneren der Vakuumkammer angeordnet ist, so dass eine lonen-Bestrahlungsöffnung dem Substrat zugewandt ist, und
die Neutralisationseinrichtung und die Ionenquelle so angeordnet sind, dass sie um einen vorgegebenen Abstand voneinander entfernt sind.

2. Abscheidevorrichtung nach Anspruch 1, wobei
ein Öffnungsbereich in der Innenwand ausgebildet ist, und
die Neutralisationseinrichtung an der Innenseite des Öffnungsbereiches ohne elektrischen Kontakt mit der Innenwand angeordnet ist.

3. Abscheidevorrichtung nach Anspruch 1, wobei
die Neutralisationseinrichtung an der Innenseite eines in der Innenwand ausgebildeten Öffnungsbereiches ohne elektrischen Kontakt mit der Innenwand angeordnet ist, und
eine Innenfläche der Innenwand eine Beschichtung aus isolierendem keramischem Material aufweist.

4. Abscheidevorrichtung nach Anspruch 1, wobei
ein bestrahltes Ionen-Leitelement (50) zum Regulieren eines Bestrahlungsbereiches der Ionen zwischen einer Ionen-Bestrahlungsöffnung der Ionenquelle und dem Substrat-Halter vorhanden ist, und
das bestrahlte Ionen-Leitelement so angeordnet ist, dass es einen Diffusionsbereich der über die Ionen-Bestrahlungsöffnung ausgestrahlten Ionen reduziert, und es in Bezug auf die Vakuumkammer elektrisch potentialfrei ist.

5. Abscheidevorrichtung nach Anspruch 1, wobei
ein bestrahltes Elektronen-Leitelement (52) zum Regulieren eines Bestrahlungsbereiches der Elektronen zwischen einer Elektronen-Bestrahlungsöffnung der Neutralisationseinrichtung und dem Substrat-Halter vorhanden ist, und
das bestrahlte Elektronen-Leitelement so angeordnet ist, dass es einen Diffusionsbereich der über die Elektronen-Bestrahlungsöffnung ausgestrahlten Elektronen reduziert, und es in Bezug auf die Vakuumkammer elektrisch potentialfrei ist.

6. Abscheidevorrichtung nach Anspruch 1, wobei
ein bestrahltes Ionen-Leitelement, das in Bezug auf die Vakuumkammer elektrisch potentialfrei ist und dazu dient, einen Bestrahlungsbereich der Ionen zu regulieren, zwischen der Ionen-Bestrahlungsöffnung der Ionenquelle und dem Substrat-Halter vorhanden ist,
ein bestrahltes Elektronen-Leitelement zum Regulieren eines Strahlungsbereiches der Elektronen, das in Bezug auf die Vakuumkammer elektrisch potentialfrei ist, zwischen einer Elektronen-Bestrahlungsöffnung der Neutralisationseinrichtung und dem Substrat-Halter vorhanden ist, und
das bestrahlte Ionen-Leitelement oder/und das bestrahlte Elektronen-Leitelement in einer Röhrenform ausgebildet ist/sind.

7. Verfahren zum Herstellen einer Dünnschichteinrichtung unter Verwendung einer Abscheidevorrichtung, die umfasst:
eine Vakuumkammer (10, 100), die geerdet und mit einer Innenwand versehen ist, die in Bezug auf die Vakuumkammer elektrisch potentialfrei ist;
einen Substrat-Halter (12), der in der Vakuumkammer gelagert ist;
ein Substrat, das durch den Substrat-Halter gehalten werden kann;
eine Abscheideeinrichtung (34, 36), die um einen vorgegebenen Abstand von dem Substrat entfernt so angeordnet ist, dass sie dem Substrat zugewandt ist;
eine Ionenquelle (38) zum Bestrahlen des Substrats mit Ionen, die an einer Seite angeordnet ist, die einer Seite gegenüberliegt, an der der Substrat-Halter im Inneren der Vakuumkammer angeordnet ist, so dass eine Ionen-Bestrahlungsöffnung dem Substrat zugewandt ist;
eine Neutralisationseinrichtung (40) zum Bestrahlen des Substrats mit Elektronen, die an der Seite der seitlichen Fläche der Vakuumkammer angeordnet ist; und
einen Verschluss (34a, 36a), der in einer unmittelbaren Umgebung einer Abscheidematerial-Bestrahlungsöffnung der Abscheideeinrichtung und einer Ionen-Bestrahlungsöffnung der Ionenquelle angeordnet ist,
wobei das Herstellungsverfahren umfasst:
einen Anordnungsschritt, in dem das Substrat in dem Substrat-Halter angeordnet wird;
einen Einstellschritt, in dem der Substrat-Halter mit einer vorgegebenen Umdrehungszahl gedreht wird, Druck in der Vakuumkammer auf einen vorgegebenen Wert eingestellt wird und eine Temperatur des Substrats auf einen vorgegebenen Wert erhöht wird;
einen Vorbereitungsschritt, in dem die Ionenquelle und die Abscheideeinrichtung in einen Ruhezustand versetzt werden; und
einen Abscheideschritt, in dem das Substrat mit dem Abscheidematerial bestrahlt wird, indem der Verschluss geöffnet wird, wobei
in dem Abscheideschritt Ionen von der Neutralisationseinrichtung ausgestrahlt werden, die nahe an dem Substrat-Halter so angeordnet ist, dass sie um einen vorgegebenen Abstand von der Ionenquelle entfernt ist.

## Revendications

1. Appareil de dépôt, comprenant :
une chambre à vide (10, 100) reliée à la terre ;
un support de substrat (12) monté dans la chambre à vide ;
un substrat pouvant être maintenu par le support de substrat ;
un moyen de dépôt (34, 36) placé à une distance prédéterminée du substrat de manière à faire face au substrat ;
un canon à ions (38) pour irradier des ions sur le substrat ; et
un neutraliseur (40) pour irradier des électrons sur le substrat, dans lequel
la chambre à vide est pourvue d'une paroi interne (30) flottant électriquement par rapport à la chambre à vide,
le neutraliseur (40) est agencé sur un côté de la chambre à vide,
le canon à ions (38) est agencé sur un côté opposé à un côté où le support de substrat (12) est agencé à l'intérieur de la chambre à vide de telle sorte qu'un orifice d'irradiation d'ions fait face au substrat, et
le neutraliseur et le canon à ions sont agencés de manière à être espacés entre eux d'une distance prédéterminée.

2. Appareil de dépôt selon la revendication 1, dans lequel
une zone d'ouverture est formée dans la paroi interne, et
le neutraliseur est agencé sur le côté interne de la zone d'ouverture sans contact électrique avec la paroi interne.

3. Appareil de dépôt selon la revendication 1, dans lequel
le neutraliseur est agencé sur le côté interne de la zone d'ouverture formée dans la paroi interne sans contact électrique avec la paroi interne, et
une surface interne de la paroi interne comporte un revêtement céramique isolant.

4. Appareil de dépôt selon la revendication 1, dans lequel
un élément de guidage d'ions irradiés (50) pour réguler une plage d'irradiation des ions est pourvu entre un orifice d'irradiation d'ions du canon à ions et le support de substrat, et
l'élément de guidage d'ions irradiés est agencé de manière à réduire une plage de diffusion des ions irradiés depuis l'orifice d'irradiation d'ions, et flotte électriquement par rapport à la chambre à vide.

5. Appareil de dépôt selon la revendication 1, dans lequel
un élément de guidage d'électrons irradiés (52) pour réguler une plage d'irradiation des électrons est pourvu entre un orifice d'irradiation d'électrons du neutraliseur et le support de substrat, et
l'élément de guidage d'électrons irradiés est agencé de manière à réduire une plage de diffusion des électrons irradiés depuis l'orifice d'irradiation d'électrons, et flotte électriquement par rapport à la chambre à vide.

6. Appareil de dépôt selon la revendication 1, dans lequel
un élément de guidage d'ions irradiés, flottant électriquement par rapport à la chambre à vide, pour réguler une plage d'irradiation des ions est pourvu entre un orifice d'irradiation d'ions du canon à ions et le support de substrat,
un élément de guidage d'électrons irradiés pour réguler une plage d'irradiation des électrons, flottant électriquement par rapport à la chambre à vide, est pourvu entre un orifice d'irradiation d'électrons du neutraliseur et le support de substrat, et
au moins un élément de guidage parmi l'élément de guidage d'ions irradiés et l'élément de guidage d'électrons irradiés est constitué avec une forme tubulaire.

7. Procédé de fabrication d'un dispositif à couches minces mettant en oeuvre un appareil de dépôt comprenant :
une chambre à vide (10, 100) reliée à la terre et pourvue d'une paroi interne qui flotte électriquement par rapport à la chambre à vide ;
un support de substrat (12) monté dans la chambre à vide ;
un substrat pouvant être maintenu par le support de substrat ;
un moyen de dépôt (34, 36) placé à une distance prédéterminée du substrat de manière à faire face au substrat ;
un canon à ions (38) pour irradier des ions sur le substrat, agencé sur un côté opposé à un côté où le support de substrat est agencé à l'intérieur de la chambre à vide de telle sorte qu'un orifice d'irradiation d'ions fait face au substrat ;
un neutraliseur (40) pour irradier des électrons sur le substrat, agencé sur le côté de la surface latérale de la chambre à vide ; et
un obturateur (34a, 36a) agencé à proximité immédiate d'un orifice d'irradiation de matériau de dépôt du moyen de dépôt et d'un orifice d'irradiation d'ions du canon à ions,
le procédé de fabrication comprenant :
une étape d'agencement du substrat dans le support de substrat ;
une étape d'établissement consistant à faire tourner le support de substrat d'un nombre de rotations prédéterminé, établir la pression dans la chambre à vide à une valeur prédéterminée, et augmenter la température du substrat jusqu'à une valeur prédéterminée ;
une étape de préparation consistant à amener le canon à ions et le moyen de dépôt dans un état de veille inactive ; et
une étape de dépôt consistant à irradier le matériau de dépôt sur le substrat en ouvrant l'obturateur, dans lequel
à l'étape de dépôt, des électrons sont irradiés à partir du neutraliseur, agencé près du support de substrat de manière à être espacé du canon à ions d'une distance prédéterminée, vers le substrat.
